# EUROPEAN PATENT SPECIFICATION

(11) **EP 4 249 931 B1**
(45) Date of publication and mention of the grant of the patent: **25.06.2025**
(21) Application number: 21893810.8
(22) Date of filing: 11.11.2021
(51) Int. Cl.: G01R 31/52, G01R 19/00, H02J 7/00, B60L 3/00, G01R 15/18, G01R 31/28

(54) **CURRENT DETECTION CIRCUIT, CURRENT LEAKAGE DETECTION METHOD, AND CHARGING SYSTEM**
STROMDETEKTIONSSCHALTUNG, STROMLECKDETEKTIONSVERFAHREN UND LADESYSTEM
CIRCUIT DE DÉTECTION DE COURANT, PROCÉDÉ DE DÉTECTION DE FUITE DE COURANT ET SYSTÈME DE CHARGE

(30) Priority: 17.11.2020 CN 202011289085
(43) Date of publication of application: 27.09.2023
(73) Proprietor: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2021/129979
(87) International publication number: WO 2022/105663

(56) References cited:
- WO-A1-2012/098054
- CN-A- 104 215 817
- CN-A- 107 534 286
- CN-A- 107 703 823
- CN-A- 112 269 148
- CN-U- 203 811 737
- JP-A- 2012 233 718
- JP-A- 2016 031 253
- JP-A- 2016 206 054
- US-A- 5 223 789
- US-A1- 2018 131 173
- US-A1- 2019 331 724

## Description

The present disclosure claims priority to Chinese Patent Application No. 202011289085.1, filed on November 17, 2020, and entitled 'current detection circuit, current leakage detection method, and charging system'.

### TECHNICAL FIELD

The present disclosure relates to a technical field of new energy, and particularly to a current detection circuit, current leakage detection method, and charging system.

### BACKGROUND

With the rapid development of the field of electric vehicles, people pay more and more attention to the safety of charging products of electric vehicles, in which the detection of leakage current in a charging process is an important requirement. By the detection of leakage current, it is possible to determine whether there is leakage current in a charging process of an electric vehicle by a charging pile, and cut off the connection between the charging pile and the electric vehicle in time when there is leakage current, so as to avoid causing greater hazards to the electric vehicle, the charging pile, and surrounding devices or people, and improve the safety of the charging process.

Patent specification US2019331724A1 discloses an excitation unit applied to an excitation coil, an excitation voltage with a voltage level alternately changing between a first high voltage value higher than a reference voltage value and a first low voltage value lower than the reference voltage value. The excitation unit includes a comparison circuit and a voltage switching circuit. The comparison circuit outputs a comparison signal having a voltage level switching between a high level and a low level depending on whether a detection voltage is greater than, or equal to or less than, a threshold voltage. The voltage switching circuit switches the voltage level of the excitation voltage between the first high voltage value and the first low voltage value according to the voltage level of the comparison signal.

Patent specification US20180131173A1 discloses a magnetic core electromagnetically coupled to two conductors that allow an AC current to flow through. An exciter is configured to supply a winding with an excitation current that is an alternating current. A current detector is configured to detect a current flowing through the winding. A DC component detector is configured to detect a DC component level from the current detected with the current detector. Two contact elements are respectively disposed along the two conductors. A discrimination controller is configured to: turn the two contact elements on when the DC component level detected with the DC component detector is less than or equal to a threshold; turn the two contact elements off when the DC component level detected with the DC component detector is greater than the threshold; and turn the two contact elements off in de-energized condition.

Therefore, how to detect the leakage current in the charging process is a technical problem urgently to be solved by those skilled in the art.

### SUMMARY

The embodiments of the present disclosure provide a current detection circuit, a current leakage detection method and a charging system, which are adopted to detect leakage current in a charging process.

In a first aspect, an embodiment of the present disclosure provides a current detection according to claim 1.

In a second aspect, an embodiment of the present disclosure provides a charging system according to claim 9.

In this way, the control circuit can control whether the charging device should supply electric energy to the outside according to the fact whether the current detection circuit outputs the indication signal, so that when there is leakage current in the first lead passing through the magnetic induction coil, i.e., when there is an electric leakage as the charging device supplies electric energy to the outside, a loop of the charging device for supplying electric energy to the outside is cut off in time, so that the charging device stops supplying electric energy to the outside, thereby reducing the occurrence of hazards and improving the safety and reliability of the charging process.

In a third aspect, an embodiment of the present disclosure provides a current leakage detection method according to claim 11.

According to the current detection circuit, the current leakage detection method and the charging system provided by the embodiments of the present disclosure, by providing the current detection circuit, it is possible to output an excitation signal to the first winding in the magnetic induction coil, and then determine whether there is leakage current in a first lead passing through the magnetic induction coil based on a feedback signal induced by the first winding and a reference signal, thereby determining whether there is an electric leakage while a charging device supplies electric energy to the outside, and providing a determination result to a control circuit. When there is an electric leakage, the control circuit can cut off a loop of the charging device for supplying electric energy to the outside in time, so that the charging device can stop supplying electric energy to the outside, thereby reducing the occurrence of hazards and improving the safety and reliability of the charging process. Meanwhile, the reaction speed for controlling the charging process can be increased to improve the timeliness. In addition, the application range of the current detection circuit is greatly widened because it is not limited by geography or climate.

### BRIEF DESCRIPTION OF THE DRAWINGS

FIG. 1 illustrates a structural diagram of a current detection circuit according to an unclaimed example;
FIG. 2 illustrates a structural diagram of a current detection circuit according to another embodiment of the present disclosure;
FIG. 3 illustrates a structural diagram of a current detection circuit according to still another embodiment of the present disclosure;
FIG. 4 illustrates a structural diagram of a current detection circuit according to yet another embodiment of the present disclosure;
FIG. 5 is a structural diagram of a current detection circuit according to yet another embodiment of the present disclosure;
FIG. 6 illustrates a specific structural diagram of a reference voltage generator according to an embodiment of the present disclosure;
FIG. 7 illustrates a structural diagram of a current detection circuit according to yet another embodiment of the present disclosure;
FIG. 8 illustrates a structural diagram of a current detection circuit according to yet another embodiment of the present disclosure;
FIG. 9 illustrates a specific structural diagram of a current generator according to an embodiment of the present disclosure;
FIG. 10 illustrates a structural diagram of a charging system according to an embodiment of the present disclosure;
FIG. 11 illustrates a structural diagram of a charging system according to an embodiment of the present disclosure;
FIG. 12 illustrates a flowchart of a current leakage detection method according to an embodiment of the present disclosure.

### Reference signs:

10: magnetic induction coil;
20: current detection circuit;
21: excitation module;
21a: signal generator;
21b: voltage dividing unit;
22: comparison module;
22a: comparison unit;
22b: first operational amplifier unit;
22c: second operational amplifier unit;
23: reference voltage generator;
24: auxiliary module;
101: charging device;
102: charged device;
103: control circuit;
104: first lead;
105: second lead;
L0: lead;
B1: first comparator;
B2: second comparator;
B3: third comparator;
Y1: first operational amplifier;
Y2: second operational amplifier;
Y3: third operational amplifier;
Q1: driver;
u1: first winding;
u2: second winding.

### DETAILED DESCRIPTION

Specific implementations of a current detection circuit, a current leakage detection method, and a charging system according to the embodiments of the present disclosure will be described in detail below with reference to the drawings. It should be noted that the described embodiments are only a part, rather than all, of the embodiments of the present disclosure. All other embodiments derived by persons skilled in the art from the embodiments of the present disclosure without making inventive efforts shall fall within the scope of the present disclosure.

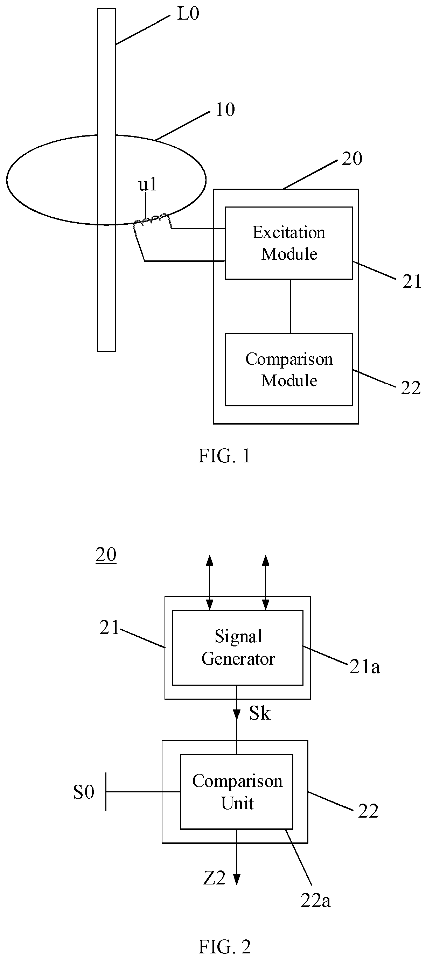

An example of the present disclosure provides a current detection circuit. As illustrated in FIG. 1, a current detection circuit 20 includes an excitation module 21 and a comparison module 22. The excitation module 21 is connected to a first winding u1 wound in a magnetic induction coil 10, and a lead L0 passes through the magnetic induction coil 10. The comparison module 22 is connected to the excitation module 21.

The excitation module 21 is configured to output an excitation signal to the first winding u1 and receive a feedback signal induced by the first winding u1.

The comparison module 22 is configured to determine whether there is leakage current in the lead L0 based on the feedback signal induced by the first winding u1 and a preset reference signal.

In this way, by providing the current detection circuit, it is possible to output an excitation signal to the first winding in the magnetic induction coil, and then determine whether there is leakage current in the lead passing through the magnetic induction coil based on the feedback signal induced by the first winding and the reference signal, which is beneficial for the outside world to respond in time and effectively based on the determination result, thereby reducing the occurrence of hazards, and improving the safety and reliability of the charging process. Meanwhile, the reaction speed for controlling the charging process can be increased to improve the timeliness. In addition, the application range of the current detection circuit is greatly widened because it is not limited by geography or climate.

It should be noted that, optionally, the detected leakage current may be AC current or DC current That is, the current detection circuit according to the embodiment of the present disclosure can detect both AC leakage current and DC leakage current. Especially when the DC leakage current is detected, the minimum detectable DC leakage current may be 0.01mA, and the detection precision may be ± 0.01%. The current detection circuit according to the embodiment of the present disclosure has an extensive application range and meets the needs of different application scenarios, thereby greatly improving the practicability of the current detection circuit. Meanwhile, the detection is faster and more accurate, which greatly improves the detection sensitivity.

Specifically, regardless of whether the DC leakage current or the AC leakage current is detected, the specific detection principle in the detection process may include: when the excitation signal is output to the first winding, under the action of the electromagnetic induction, the excitation signal enables the magnetic induction coil to generate a magnetic field; when there is leakage current in the lead, the magnetic field generated by the excitation signal may be changed, which causes induced electromotive forces at two ends of the first winding, and then induced current can be generated when the two ends of the first winding form a loop.

The lead may include a neutral line and a live line. If there is a difference between the current output from the live line and the current input from the neutral line, it can be considered that there is leakage current in the lead.

At this time, there is induced current (i.e., a feedback signal) in the excitation module connected to the first winding, and it can be determined whether there is leakage current in the lead based on a relationship between the feedback signal and the reference signal.

Therefore, regardless of whether the DC leakage current or the AC leakage current is detected, the reference signals used in the detection process may be the same, and the excitation signals used in the detection process may be the same. Of course, the reference signal and the excitation signal can be adjusted and changed according to the type of the leakage current, as long as the leakage current can be detected. The specific implementation forms of the reference signal and the excitation signal can be set according to actual needs, which is not limited here.

In addition, regardless of whether the DC leakage current or the AC leakage current is detected, the waveform of the feedback signal is determined by the type of the leakage current in the lead, so the implementation form of the feedback signal corresponds to the type of the leakage current in the lead.

Moreover, the excitation signal may have adjustable frequency and amplitude which are determined depending on factors such as the specific structure of the current detection circuit, the detection precision, etc., which is not limited here.

Furthermore, the waveform of the excitation signal may be, but not limited to, a square wave, or other waveforms, such as a cosine wave, which can be set according to actual needs and is not limited here.

Optionally, in the embodiment of the present disclosure, the comparison module is specifically configured to:
determine whether an absolute value of the feedback signal is greater than the reference signal;
determine that there is leakage current in the lead, if the absolute value of the feedback signal is greater than the reference signal; and
determine that there is no leakage current in the lead, if the absolute value of the feedback signal is not greater than the reference signal.

The feedback signal may be a positive voltage or a negative voltage, and correspondingly, the reference voltage may be set as a positive voltage, so that the absolute value of the feedback signal can be compared with the reference voltage.

In this way, by comparing the the feedback signal with the reference signal, it is possible to quickly and effectively determine whether there is leakage current in the lead, thereby improving the detection efficiency of the leakage current.

Optionally, in the embodiment of the present disclosure, as illustrated in FIG. 2, the comparison module 22 includes a comparison unit 22a.

The comparison unit 22a is configured to: determine an effective signal and an interference signal in the feedback signal (denoted by Sk), and amplify the effective signal to obtain a first signal (denoted by Z1); determine whether there is leakage current in the lead based on the first signal Z1 and the reference signal; and output a second signal Z2 if it is determined that there is leakage current in the lead.

In this way, by providing the comparison unit, the function of the comparison module can be realized, thereby detecting the leakage current in the lead. Meanwhile, it is possible to improve the detection precision of the leakage current and the accuracy of the detection result, thus providing accurate and effective reference for subsequent processing.

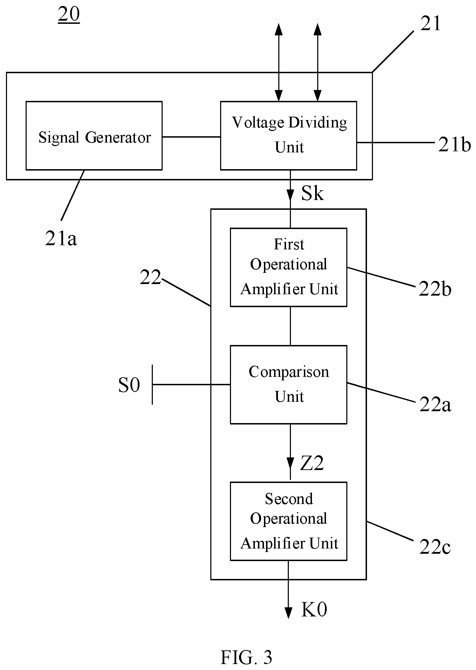

Optionally, in the embodiment of the present disclosure, as illustrated in FIG. 3, the comparison module 22 further includes a first operational amplifier unit 22b, one end of which is connected to the comparison unit 22a, and the other end of which is connected to the excitation module 21.

The first operational amplifier unit 22b is configured to perform signal amplification processing on the feedback signal Sk before the effective signal and the interference signal in the feedback signal Sk are determined.

In this way, it is possible to effectively extract the effective signal and eliminate the interference signal, so that the comparison unit can accurately and effectively determine whether there is leakage current in the lead, and the accuracy of the determination result can be improved.

Optionally, in the embodiment of the present disclosure, as illustrated in FIG. 3, the comparison module 22 further includes a second operational amplifier unit 22c, one end of which is connected to the comparison unit 22a, and the other end of which constitutes an output end of the comparison module 22. The second operational amplifier unit 22c is configured to perform power amplification processing on the second signal Z2.

In this way, by performing the amplification processing on the second signal, which can also be understood as power-level amplification processing, it is beneficial for the external device to identify the second signal upon receipt of it, thereby promoting the timely and effective processing and response by the external device, and improving the safety and reliability of the charging process.

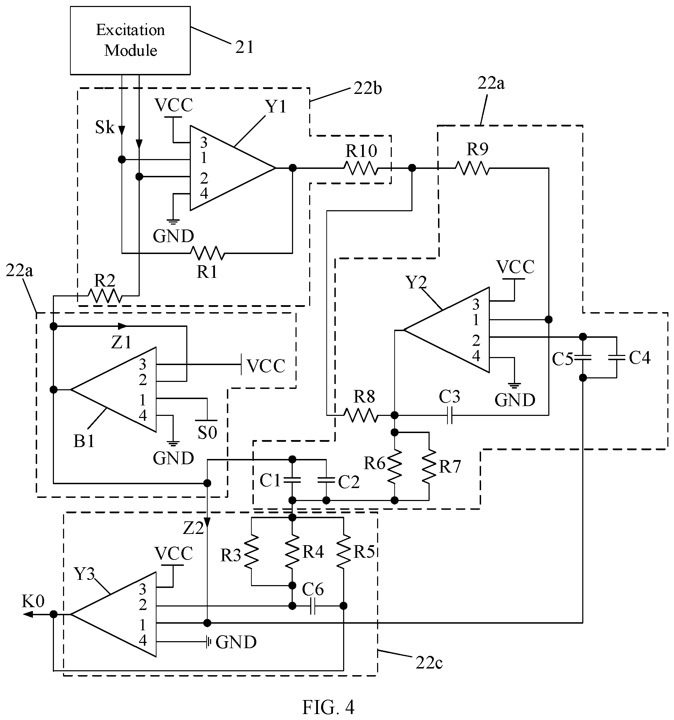

Specifically, in the embodiment of the present disclosure, as illustrated in FIG. 4, the comparison unit 22a includes a first comparator B1, a second operational amplifier Y2, a sixth resistor R6, a seventh resistor R7, an eighth resistor R8, a ninth resistor R9, a first capacitor C1, a second capacitor C2, a third capacitor C3, a fourth capacitor C4, and a fifth capacitor C5.

The first operational amplifier unit 22b may include a first operational amplifier Y1, a first resistor R1, a second resistor R2, and a tenth resistor R10.

The second operational amplifier unit 22c may include a third operational amplifier Y3, a third resistor R3, a fourth resistor R4, a fifth resistor R5, and a sixth capacitor C6.

The first operational amplifier Y1 has a first input end connected to a first end of the first resistor R1 and the excitation module 21, respectively. The first operational amplifier Y1 has a second input end connected to a first end of the second resistor R2, and the excitation module 21, respectively. The first operational amplifier Y1 has a third input end connected to a power signal terminal VCC, and a fourth input end connected to a ground terminal GND. The first operational amplifier Y1 has an output end electrically connected to a second end of the first resistor R1, and a first end of the tenth resistor R10, respectively.

The second operational amplifier Y2 has a first input end connected to a first end of the third capacitor C3, and a first end of the ninth resistor R9, respectively. The second operational amplifier Y2 has a second input end connected to a first end of the fourth capacitor C4, and a first end of the fifth capacitor C5, respectively. The second operational amplifier Y2 has a third input end connected to the power signal terminal VCC, and a fourth input end connected to the ground terminal GND. The second operational amplifier Y2 has an output end connected to a first end of the eighth resistor R8, a second end of the third capacitor C3, a first end of the sixth resistor R6, and a first end of the seventh resistor R7, respectively;

The third operational amplifier Y3 has a first input terminal connected to a first end of the first capacitor C1, a first end of the second capacitor C2, a second end of the fourth capacitor C4, and a second end of the fifth capacitor C5, respectively. The third operational amplifier Y3 has a second input end connected to a first end of the third resistor R3, a first end of the fourth resistor R4, and a first end of the sixth capacitor C6, respectively. The third operational amplifier Y3 has a third input terminal connected to the power signal terminal VCC, and a fourth input terminal connected to the ground terminal GND. The third operational amplifier Y3 has an output end connected to an output end of the current detection circuit, a second end of the sixth resistor C6, and a first end of the fifth resistor R5, respectively.

The first comparator B1 has a first input terminal connected to a reference voltage terminal S0 used to provide a reference signal, and a second input end connected to an output end of the first comparator B1, a second end of the second resistor R2, and a first end of the first capacitor C1, respectively. The first comparator B1 has a third input end connected to the power signal terminal VCC, and a fourth input end connected to the ground terminal GND.

A second end of the third resistor R3, a second end of the fourth resistor R4, a second end of the fifth resistor R5, a second end of the sixth resistor R6, and a second end of the seventh resistor R7 are all connected to a second end of the first capacitor C1.

A second end of the eighth resistor R8 and a second end of the ninth resistor R9 are both connected to a second end of the tenth resistor R10.

In this way, through the cooperative use of the first operational amplifier, the first resistor, the second resistor and the tenth resistor, it is possible to realize the function of the first operational amplifier unit to implement the first-stage amplification processing on the feedback signal. In addition, through the cooperative use of the sixth resistor, the seventh resistor, the eighth resistor, the ninth resistor, the first capacitor, the second capacitor, the third capacitor, the fourth capacitor and the fifth capacitor, it is possible to filter out the interference signal in the first signal and remain the effective signal, so as to facilitate the second operational amplifier to perform the second-stage amplification processing on the effective signal. In addition, through the cooperative use of the third operational amplifier, the third resistor, the fourth resistor, the fifth resistor and the sixth capacitor, it is possible to perform the three-stage amplification processing on a third signal, thereby achieving a power-level signal amplification.

Optionally, in the embodiment of the present disclosure, the comparison module further includes a seventh capacitor disposed between the power signal terminal and the ground terminal.

In FIG. 4, the first operational amplifier, the second operational amplifier, the third operational amplifier and the first comparator may be connected to the same power signal terminal and connected to the same ground terminal. In this case, a seventh capacitor may be disposed between the power signal terminal and the ground terminal in the comparison module to further realize the signal filtering function, thereby improving the accuracy of the output result of the comparison module.

It should be noted that, optionally, in the embodiment of the present disclosure, the specific structure of the comparison module is not limited to that illustrated in FIG. 4. That is, the structure illustrated in FIG. 4 is merely a specific embodiment for realizing the function of the comparison module, and the specific structure of the comparison module may also adopt any other structure well known to those skilled in the art and capable of realizing the function of the comparison module, which is not limited here.

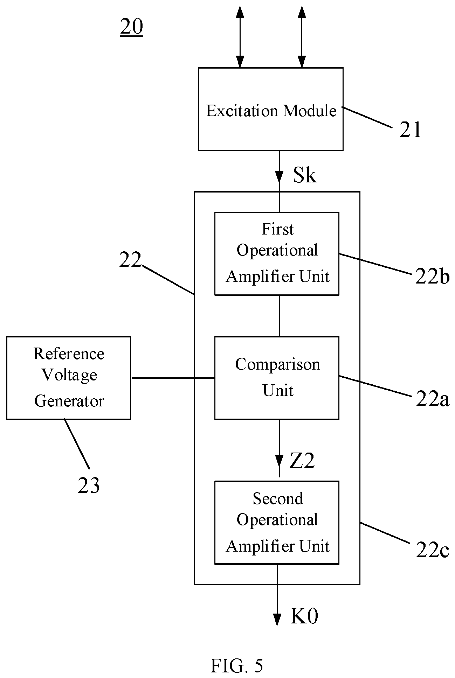

Optionally, in the embodiment of the present disclosure, as illustrated in FIG. 5, the current detection circuit 20 may further include a reference voltage generator 23, which may be connected to the comparison unit 22a. The reference voltage generator 23 is configured to provide a reference voltage Vref to the comparison unit 22a.

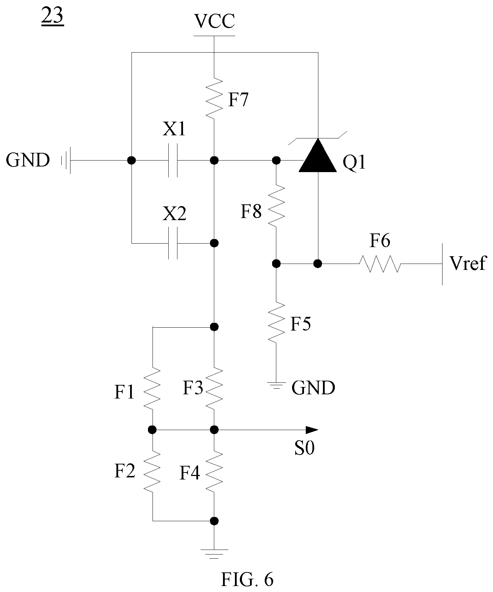

The specific structure of the reference voltage generator 23 may be as illustrated in FIG. 6, i.e., it includes a plurality of capacitors (i.e., capacitors denoted by X1 and X2), a plurality of resistors (i.e., resistors denoted by F1 to F8) and a stabilivolt (i.e., Q1), specific connection relationship of which may be seen in FIG. 6, which will not be described in detail here.

Of course, the specific structure of the reference voltage generator may also be any other structure capable of generating a reference voltage well known to those skilled in the art, and may be set and selected according to actual needs, which is not limited here.

In this way, by providing the reference voltage generator, it is possible to provide a reference voltage with high precision and consistency for the comparison unit, thereby improving the accuracy of the detection result of the leakage current. Meanwhile, the reference voltage can be generated by the reference voltage generator itself without an external application or input, thereby reducing the dependence on the external signal.

Optionally, in the embodiment of the present disclosure, as illustrated in FIG. 2, the excitation module 21 includes a signal generator 21a. The signal generator 21a is configured to generate the excitation signal.

In this way, by providing the signal generator, it is possible to effectively realize the function of the excitation module, thereby detecting the leakage current in the lead.

Specifically, in the embodiment of the present disclosure, as illustrated in FIG. 3, the excitation module 21 further includes a voltage dividing unit 21b, one end of which is connected to the signal generator 21a, and the other end of which is connected to the first winding u1. The voltage dividing unit 21b is configured to perform voltage division processing on the excitation signal before the excitation signal is output to the first winding.

In this way, through the voltage division processing on the excitation signal, it is possible to effectively transmit the processed excitation signal to the two ends of the first winding, thereby facilitating the subsequent detection of the leakage current in the lead.

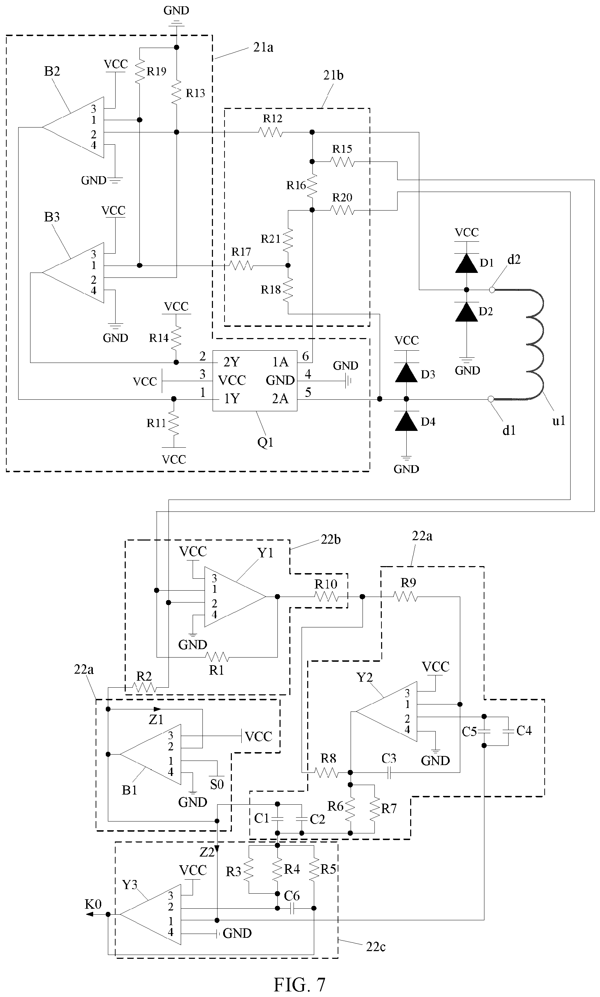

Optionally, in the embodiment of the present disclosure, as illustrated in FIG. 7, the signal generator 21a includes a driver Q1, a second comparator B2, a third comparator B3, a thirteenth resistor R13, a nineteenth resistor R19, an eleventh resistor R11 and a fourteenth resistor R14.

The voltage dividing unit 21b includes a twelfth resistor R12, a fifteenth resistor R15, a sixteenth resistor R16, a seventeenth resistor R17, an eighteenth resistor R18, a twentieth resistor R20 and a twenty-first resistor R21.

The second comparator B2 has a first input end connected to a first input end of the third comparator B3, a first end of the nineteenth resistor R19, and a first end of the seventeenth resistor R17, respectively. The second comparator B2 has a second input end connected to a second input end of the third comparator B3, a first end of the thirteenth resistor R13, and a first end of the twelfth resistor R12, respectively. The second comparator B2 has a third input end connected to a power signal terminal VCC for providing a power signal, a fourth input end connected to a ground terminal GND, and an output end connected to a first pin of a driver Q1 and a first end of the eleventh resistor R11, respectively.

The third comparator B3 has a third input end connected to the power signal terminal VCC, a fourth input end connected to the ground terminal GND, and an output end connected to a second pin of the driver Q1 and a first end of the fourteenth resistor R14, respectively;

The driver Q1 has a third pin connected to the power signal terminal VCC, a fourth pin connected to the ground terminal GND, and a fifth pin connected to a first end d1 of the first winding u1 and a first end of the eighteenth resistor R18, respectively. The driver Q1 has a sixth pin connected to a first end of the sixteenth resistor R16, a first end of the twentieth resistor R20, and a first end of the twenty-first resistor R21, respectively;

A second end of the thirteenth resistor R13 and a second end of the nineteenth resistor R19 are both connected to the ground terminal GND.

A second end of the eleventh resistor R11 and a second end of the fourteenth resistor R14 are both connected to the power signal terminal VCC.

A second end of the twelfth resistor R12 is connected to a second end of the sixteenth resistor R16, a first end of the fifteenth resistor R15, and a second end d2 of the first winding u1, respectively.

A second end of the fifteenth resistor R15 is connected to the comparison module 21.

A second end of the eighteenth resistor R18 is connected to a second end of the twenty-first resistor R21 and a second end of the seventeenth resistor R17, respectively.

A second end of the twentieth resistor R20 is connected to the comparison module 21.

In this way, through the cooperative work of the above structures, it is possible to generate the excitation signal, and perform the voltage division processing on the excitation signal, thereby achieving the excitation of the magnetic induction coil and promoting the detection of the leakage current.

Optionally, in the embodiment of the present disclosure, as illustrated in FIG. 7, the excitation module 21 further includes a first diode D1 to a fourth diode D4.

An anode of the first diode D1 and a cathode of the second diode d2 are both connected to the second end d2 of the first winding u1. A cathode of the first diode D1 is connected to the power signal terminal VCC. An anode of the second diode D2 is connected to the ground terminal GND.

An anode of the third diode D3 and a cathode of the fourth diode D4 are both connected to the first end d1 of the first winding u1. A cathode of the third diode D3 is connected to the power signal terminal VCC. An anode of the fourth diode D4 is connected to the ground terminal GND.

In this way, by providing a plurality of diodes, it is possible to protect the signal processing unit due to the unidirectional conduction function of the diodes, thereby ensuring that the signal processing unit can transmit signals normally and effectively.

Optionally, in the embodiment of the present disclosure, the excitation module further includes an eighth capacitor to an eleventh capacitor.

The eighth capacitor and the ninth capacitor are connected in parallel between a third pin of the driver and a fourth pin of the driver.

A first end of the tenth capacitor and a first end of the eleventh capacitor are connected to a third input end of the second comparator and a fourth input end of the second comparator, respectively. A second end of the tenth capacitor and a second end of the eleventh capacitor are connected to a third input end of the third comparator and a fourth input end of the third comparator, respectively.

In FIG. 7, the second comparator and the third comparator may be connected to the same power signal terminal and connected to the same ground terminal. In this case a tenth capacitor and an eleventh capacitor arranged in parallel may be disposed between the power signal terminal and the ground terminal to further realize the signal filtering function, thereby improving the accuracy of the output result of the signal generating unit.

It should be noted that, optionally, in the embodiment of the present disclosure, the specific structure of the excitation module is not limited to that illustrated in FIG. 7. That is, the structure illustrated in FIG. 7 is merely a specific embodiment for realizing the function of the excitation module, and the specific structure of the excitation module may also adopt any other structure well known to those skilled in the art and capable of realizing the function of the excitation module, which is not limited here.

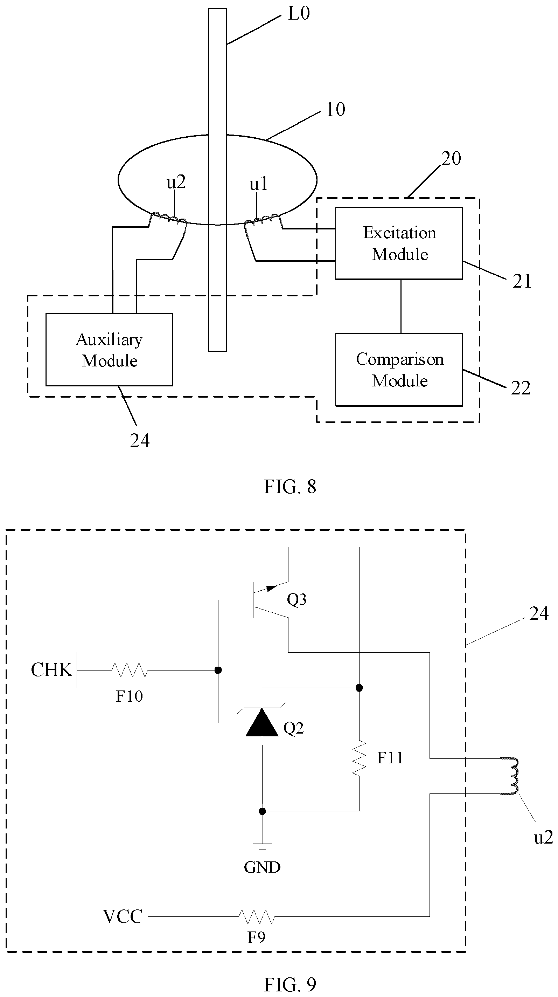

In the embodiment of the present disclosure, as illustrated in FIG. 8, the current detection circuit 20 further includes an auxiliary module 24.

The auxiliary module 24 is connected to the second winding u2 wound in the magnetic induction coil L0. The auxiliary module 24 is configured to output a preset current signal to the second winding u2 in an initialization stage where no current passes through the lead L0, so as to determine whether the excitation module 21 and the comparison module 22 can work normally.

It should be noted that the first winding and the second winding wound in the magnetic induction coil are two different windings. When there is no current passing through the lead, a current signal may be input into the second winding to simulate the situation that there is leakage current in the lead passing through the magnetic induction coil. When the excitation module inputs the excitation signal into the first winding, the magnetic field generated by the excitation signal will be changed because of the current in the second winding. If it is determined, through the excitation module and the comparison module, that the feedback signal induced by the first winding is greater than the reference signal, it may be determined that the excitation module and the comparison module can work normally and effectively, thereby achieving the self-check of the current detection circuit.

Optionally, in the embodiment of the present disclosure, the auxiliary module 24 includes a current generator.

In this way, it is possible to realize the function of the auxiliary module through a simple structure, thereby achieving the self-check of the current detection circuit.

The structure of the current generator in the auxiliary module 24 is illustrated in FIG. 9, i.e., it includes a plurality of resistors (denoted by F9, F10 and F11), a triode (denoted by Q3) and a voltage regulator (denoted by Q2), the specific connection relationship of which can be seen in FIG. 9 and will not be described in detail here. In FIG. 9, CHK is a self-check signal for simulating the generation of the leakage current, so as to detect whether the induction coil can induce normally. After the self-check signal is subjected to the actions of the resistor, the triode and the stabilivolt illustrated in FIG. 9, a preset current signal is output to the second winding u2.

Of course, the specific structure of the current generator may also be any other structure capable of generating current well known to those skilled in the art, and may be set and selected according to actual needs, which is not limited here.

The working process of the current detection circuit according to the embodiment of the present disclosure will be described with reference to the structural diagram illustrated in FIG. 7.

The second comparator B2 and the third comparator B3 work under the cooperation of the thirteenth resistor R13 and the nineteenth resistor R19, and the generated signals are input to the first pin and the second pin of the driver Q1, respectively. Through the pull-up of the eleventh resistor R11 disposed at the first pin of the driver Q1 and the fourteenth resistor R14 disposed at the second pin of the driver Q1, the output capability of the driver Q1 can be improved, so that the excitation signal, whose frequency and amplitude can be adjusted according to actual needs, output by the driver Q1 through the fifth pin and the sixth pin are more accurate and effective;
next, through the cooperative use of the twelfth resistor R12, sixteenth resistor R16, seventeenth resistor R17, eighteenth resistor R18 and twenty-first resistor R21, the excitation signal may be transmitted to the first winding u1, so that a magnetic field is generated in the magnetic induction coil;
when there is leakage current in the lead passing through the magnetic induction coil, the magnetic field will be changed because of the existence of the leakage current, so that the first winding u1 outputs a feedback signal;
the excitation module can be protected since the first diode D1 to the fourth diode D4 have the unidirectional conduction function, thereby avoiding the influence of the feedback signal on the excitation module;
moreover, the feedback signal may firstly pass through the fifteenth resistor R15, the sixteenth resistor R16, the eighteenth resistor R18, the twentieth resistor R20 and the twenty-first resistor R21 for voltage division processing by these resistors, and then is transmitted to the first input end and the second input end of the first operational amplifier Y1;
the first operational amplifier Y1 performs amplification processing on the feedback signal under the cooperative work of the first resistor R1 and the tenth resistor R10, and then transmits the feedback signal that has been performed with the amplification processing to the comparison unit 22a;
in the comparison unit 22a, the effective information in the feedback signal that has been performed with the amplification processing may be extracted by filtering processing through the first capacitor C1 to the fifth capacitor C5, then the extracted effective information may be subjected to amplification processing through the cooperative work of the eighth resistor R8, the ninth resistor R9 and the second operational amplifier Y2, and thereafter the resultant first signal Z1 is output from the sixth resistor R6 and the seventh resistor R7 and transmitted to the first comparator B1 which can implement the following and comparison of the reference voltage and transmits the second signal Z2 to the third operational amplifier Y3;
an indication signal K0 (for example, but not limited to a high-level signal) is output through the cooperative amplification of the third operational amplifier Y3, the third resistor R3 to the fifth resistor R5, and the sixth capacitor C6, so as to inform the external device that there is leakage current in the lead, thereby guiding the external device to respond in time and effectively, and improving the safety and reliability of the charging process.

It should be emphasized that since the current detection circuit according to the embodiment of the present disclosure is composed of simple components, it is beneficial to reduce the manufacturing cost of the current detection circuit. Meanwhile, the overall occupied area of the current detection circuit is small, so that the overall size of the current detection circuit is small, which is convenient for installation and use in various charging systems and greatly improves the practicability of the current detection circuit.

In addition, according to the waveform of the current signal, the types of the leakage current at present mainly include a sinusoidal current signal, a current signal containing a pulsating DC component and a current signal containing a smooth DC component. The current detection circuit according to the embodiment of the present disclosure can detect the above three types of leakage current and is not limited by the type of the leakage current to be detected during actual use. Therefore, the current detection circuit according to the embodiment of the present disclosure has a wide application range.

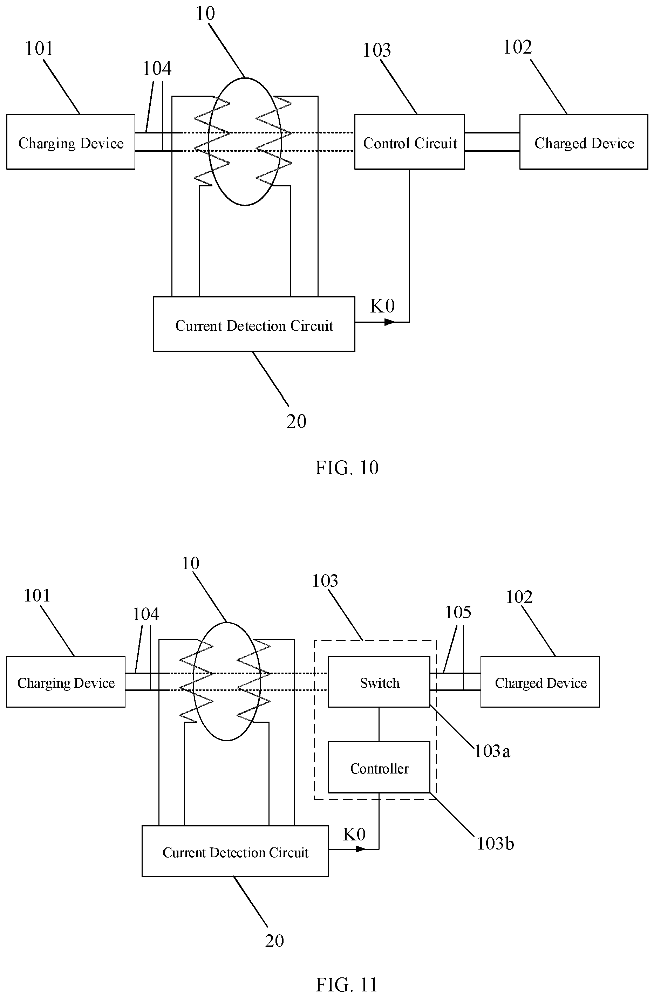

Based on the same inventive concept, an embodiment of the present disclosure provides a charging system as illustrated in FIG. 10, which may include a charging device 101, a magnetic induction coil 10, a control circuit 103, and a current detection circuit 20.

The current detection circuit 20 is the aforementioned current detection circuit according to the embodiment of the present disclosure, and the current detection circuit 20 is connected to the magnetic induction coil 10 and the control circuit 103, respectively. The control circuit 103 is connected to the charging device 101 through a first lead 104 which passes through the magnetic induction coil 10.

The current detection circuit 20 is configured to output an indication signal K0 when it is determined that there is leakage current in the first lead 104.

The control circuit is configured to control the charging device 101 to stop supplying electric energy to the outside upon receipt of the indication signal K0. or control the charging device 101 to supply electric energy to the outside upon no receipt of the indication signal K0.

In this way, the control circuit can control whether the charging device should supply electric energy to the outside according to the fact whether the current detection circuit outputs the indication signal. Therefore, when there is leakage current in the first lead passing through the magnetic induction coil, i.e., when there is an electric leakage as the charging device supplies electric energy to the outside, a loop of the charging device for supplying electric energy to the outside is cut off in time, so that the charging device stops supplying electric energy to the outside, thereby reducing the occurrence of hazards and improving the safety and reliability of the charging process.

In addition, when the control circuit cuts off the loop of the charging device for supplying electric energy to the outside, with a response speed at a millisecond-level and at the earliest within 0.01ms, thereby greatly improving the control of the charging system and the safety and reliability of the charging process.

Optionally, in an embodiment of the present disclosure, as illustrated in FIG. 10, the first lead may include a natural line and a live line, both of which can pass through the magnetic induction coil 10.

Specifically, in an embodiment of the present disclosure, as illustrated in FIG. 11, the control circuit 103 may be connected to a charged device 102 through a second lead 105, and correspondingly, the second lead 105 may also include a neutral lead and a live lead.

Optionally, in an embodiment of the present disclosure, as illustrated in FIG. 11, the control circuit 103 may include a controller 103b and a switch 103a. The switch 103a may be disposed between the charging device 101 and the charged device 102. The controller 103b is connected to the switch 103a and the current detection circuit 20, respectively.

That is, the switch, rather than the controller, is disposed on the neutral line and the live line.

The controller may control the switch to be switched off when receiving the indication signal, so as to cut off the connection between the charging device and the charged device and stop the charging process; or, the controller may control the switch to be switched on when not receiving the indication signal, so as to keep the connection between the charging device and the charged device and maintain the normal charging process.

In addition, the charging system may be provided with at least one switch. When there is one switch, it may be disposed on the neutral line or the live line. Alternatively, when there are two switches, one of which may be disposed on the neutral line and the other of which may be disposed on the live line.

Specifically, in an embodiment of the present disclosure, the switch may be, but not limited to, a relay, and may be any other structure capable of realizing the switch function well known to those skilled in the art, which is not limited here.

Optionally, in an embodiment of the present disclosure, the connection mode between the first winding and the current detection circuit may include:
mode 1: the two ends of the first winding are provided with leads, and the current detection circuit may be connected to the first winding through the leads;
mode 2: the two ends of the first winding are provided with welding points, and the current detection circuit may be connected to the welding points by welding, so as to be connected to the first winding.

One of the modes 1 and 2 may be selected to realize the connection between the first winding and the current detection circuit depending on the actual situation, so as to meet the needs of different application scenarios and improve the design flexibility.

Based on the same inventive concept, an embodiment of the present disclosure provides a current leakage detection method, the implementation principle of which is similar to that of the aforementioned current detection circuit, and the specific implementation of the current detection circuit as described above may be referred to for the implementation of the detection method, and the repetitive description is omitted herein.

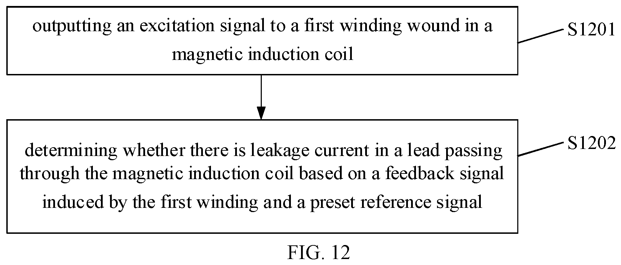

Specifically, as illustrated in FIG. 12, the current leakage detection method according to the embodiment of the present disclosure may include:
S1201: outputting an excitation signal to a first winding wound in a magnetic induction coil; and
S1202: determining whether there is leakage current in a lead passing through the magnetic induction coil according to a feedback signal induced by the first winding and a preset reference signal.

In this way, it is possible to output an excitation signal to the first winding in the magnetic induction coil, and then determine whether there is leakage current in the lead passing through the magnetic induction coil based on the feedback signal induced by the first winding and the reference signal, thereby responding to the electric leakage in time and effectively based on the determination result, reducing the occurrence of hazards, and improving the safety and reliability of the charging process. Meanwhile, the reaction speed for controlling the charging process can be increased to improve the timeliness. In addition, the application range of the current detection circuit is greatly widened because it is not limited by geography or climate.

Optionally, in an embodiment of the present disclosure, determining whether there is leakage current in the lead passing through the magnetic induction coil based on the feedback signal and the preset reference signal includes:
determining whether an absolute value of the feedback signal is greater than the reference signal;
determining that there is leakage current in the lead, if the absolute value of the feedback signal is greater than the reference signal; and
determining that there is no leakage current in the lead, if the absolute value of the feedback signal is not greater than the reference signal.

## Claims

1. A current detection circuit (20) for determining whether there is leakage current in a lead (L0) passed through a magnetic induction coil (10) that comprises a first winding (u1), wherein the current detection circuit (20) comprises an excitation module (21) and a comparison module (22), the excitation module (21) is configured to be connected to the first winding (u1) , and the comparison module (22) is connected to the excitation module (21);
the excitation module (21) is configured to output an excitation signal to the first winding (u1) and receive a feedback signal (Sk) induced by the first winding (u1);
the comparison module (22) is configured to determine whether there is leakage current in the lead (L0) based on the feedback signal (Sk) induced by the first winding (u1) and a preset reference signal;
**characterized in that**
the magnetic induction coil (10) further comprises a second winding (u2);
the current detection circuit (20) further comprises an auxiliary module (24), and the auxiliary module (24) is configured to be connected to the second winding (u2);
the auxiliary module (24) is configured to output a preset current signal to the second winding (u2) at an initialization stage where no current passes through the lead (L0), so as to determine whether the excitation module (21) and the comparison module (22) are able to work normally, wherein the preset current signal changes a magnetic field generated by the excitation signal when the excitation module (21) inputs the excitation signal into the first winding (u1).

2. The current detection circuit (20) according to claim 1, wherein the comparison module (22) is specifically configured to:
determine whether an absolute value of the feedback signal (Sk) is greater than the reference signal;
determine that there is leakage current in the lead (L0), if the absolute value of the feedback signal (Sk) is greater than the reference signal;
determine that there is no leakage current in the lead (L0), if the absolute value of the feedback signal (Sk) is not greater than the reference signal.

3. The current detection circuit (20) according to claim 1, wherein the excitation module (21) comprises a signal generator (21a) configured to generating the excitation signal.

4. The current detection circuit (20) according to claim 3, wherein the excitation module (21) further comprises a voltage dividing unit (21b) connected between the signal generator (21a) and the first winding (u1);
the voltage dividing unit (21b) is configured to perform voltage division processing on the excitation signal before the excitation signal is output to the first winding (u1).

5. The current detection circuit (20) according to claim 1, wherein the comparison module (22) comprises a comparison unit (22a);
the comparison unit (22a) is configured to:
determine an effective signal and an interference signal in the feedback signal (Sk), and amplify the effective signal to obtain a first signal (Z1);
determine whether there is leakage current in the lead (L0) based on the first signal (Z1) and the reference signal; and
output a second signal (Z2) if it is determined that there is leakage current in the lead (L0).

6. The current detection circuit (20) according to claim 5, wherein the comparison module (22) further comprises a first operational amplifier unit (22b) connected between the comparison unit (22a) and the excitation module (21);
the first operational amplifier unit (22b) is configured to perform signal amplification processing on the feedback signal (Sk) before the effective signal and the interference signal in the feedback signal (Sk) are determined.

7. The current detection circuit (20) according to claim 5, wherein the comparison module (22) further comprises a second operational amplifier unit (22c) connected to the comparison unit (22a);
the second operational amplifier unit (22c) is configured to perform power amplification processing on the second signal (Z2).

8. The current detection circuit (20) according to claim 1, wherein the auxiliary module (24) comprises a current generator.

9. A charging system, comprising a charging device (101), a magnetic induction coil (10), a control circuit (103), and the current detection circuit (20) according to any one of claims 1 to 8;
the current detection circuit (20) is connected to the magnetic induction coil (10) and the control circuit (103), respectively, and the control circuit (103) is connected to the charging device (101) through a first lead (104) which passes through the magnetic induction coil (10);
the current detection circuit (20) is configured to output an indication signal when it is determined that there is leakage current in the first lead (104);
the control circuit (103) is configured to control the charging device (101) to stop supplying electric energy to the outside upon receipt of the indication signal, and control the charging device (101) to supply electric energy to the outside upon no receipt of the indication signal.

10. The charging system according to claim 9, wherein the first lead (104) comprises a neutral line and a live line.

11. A current leakage detection method for determining whether there is leakage current in a lead (L0) passed through a magnetic induction coil (10) that comprises a first winding (u1), wherein the current leakage detection method comprises:
outputting, by an excitation module (21), an excitation signal to the first winding (u1), wherein the excitation module (21) is connected to the first winding (u1); and
determining, by a comparison module (22), whether there is leakage current in a lead (L0) passing through the magnetic induction coil (10) based on a feedback signal (Sk) induced by the first winding (u1) and a preset reference signal, wherein the comparison module (22) is connected to the excitation module (21);
**characterized in that**
the magnetic induction coil (10) further comprises a second winding (u2), and the current leakage detection method further comprises:
outputting, by an auxiliary module (24), a preset current signal to the second winding (u2) at an initialization stage where no current passes through the lead (L0), so as to determine whether the excitation module (21) and the comparison module (22) are able to work normally, wherein the preset current signal changes a magnetic field generated by the excitation signal when the excitation module (21) inputs the excitation signal into the first winding (u1).

## Patentansprüche

1. Stromdetektionsschaltung (20) zum Bestimmen, ob ein Leckstrom in einer Leitung (L0) vorhanden ist, die durch eine magnetische Induktionsspule (10) geführt wird, die eine erste Wicklung (u1) aufweist, wobei die Stromdetektionsschaltung (20) ein Erregungsmodul (21) und ein Vergleichsmodul (22) aufweist, wobei das Erregungsmodul (21) so konfiguriert ist, dass es mit der ersten Wicklung (u1) verbunden ist, und das Vergleichsmodul (22) mit dem Erregungsmodul (21) verbunden ist;
wobei das Erregungsmodul (21) so konfiguriert ist, dass es ein Erregungssignal an die erste Wicklung (u1) ausgibt und ein von der ersten Wicklung (u1) induziertes Rückkopplungssignal (Sk) empfängt;
wobei das Vergleichsmodul (22) so konfiguriert ist, dass es auf der Grundlage des von der ersten Wicklung (u1) induzierten Rückkopplungssignals (Sk) und eines voreingestellten Referenzsignals bestimmt, ob in der Leitung (L0) ein Leckstrom vorhanden ist;
**dadurch gekennzeichnet, dass**
die magnetische Induktionsspule (10) des Weiteren eine zweite Wicklung (u2) aufweist;
die Stromdetektionsschaltung (20) des Weiteren ein Hilfsmodul (24) aufweist, und das Hilfsmodul (24) so konfiguriert ist, dass es mit der zweiten Wicklung (u2) verbunden ist;
das Hilfsmodul (24) so konfiguriert ist, dass es ein voreingestelltes Stromsignal an die zweite Wicklung (u2) in einer Initialisierungsphase ausgibt, in der kein Strom durch die Leitung (L0) fließt, um zu bestimmen, ob das Erregungsmodul (21) und das Vergleichsmodul (22) in der Lage sind, normal zu arbeiten, wobei das voreingestellte Stromsignal ein durch das Erregungssignal erzeugtes Magnetfeld ändert, wenn das Erregungsmodul (21) das Erregungssignal in die erste Wicklung (u1) eingibt.

2. Stromdetektionsschaltung (20) nach Anspruch 1, bei der das Vergleichsmodul (22) speziell dafür konfiguriert ist:
festzustellen, ob ein absoluter Wert des Rückkopplungssignals (Sk) größer ist als das Referenzsignal;
festzustellen, dass in der Leitung (L0) ein Leckstrom vorhanden ist, wenn der Absolutwert des Rückkopplungssignals (Sk) größer ist als das Referenzsignal;
festzustellen, dass kein Leckstrom in der Leitung (L0) vorhanden ist, wenn der Absolutwert des Rückkopplungssignals (Sk) nicht größer als das Referenzsignal ist.

3. Stromdetektionsschaltung (20) nach Anspruch 1, bei der das Erregungsmodul (21) einen Signalgenerator (21a) aufweist, der zur Erzeugung des Erregungssignals konfiguriert ist.

4. Stromdetektionsschaltung (20) nach Anspruch 3, bei der das Erregungsmodul (21) des Weiteren eine Spannungsteilungseinheit (21b) aufweist, die zwischen dem Signalgenerator (21a) und der ersten Wicklung (u1) angeschlossen ist;
die Spannungsteilungseinheit (21b) so konfiguriert ist, dass sie eine Spannungsteilungsverarbeitung an dem Erregungssignal durchführt, bevor das Erregungssignal an die erste Wicklung (u1) ausgegeben wird.

5. Stromdetektionsschaltung (20) nach Anspruch 1, bei der das Vergleichsmodul (22) eine Vergleichseinheit (22a) aufweist;
die Vergleichseinheit (22a) so konfiguriert ist, dass sie:
ein effektives Signal und ein Störsignal im Rückkopplungssignal (Sk) bestimmt und das effektive Signal verstärkt, um ein erstes Signal (Z1) zu erhalten;
bestimmt, ob ein Leckstrom in der Leitung (L0) vorhanden ist, basierend auf dem ersten Signal (Z1) und dem Referenzsignal; und
ein zweites Signal (Z2) ausgibt, wenn festgestellt wird, dass in der Leitung (L0) ein Leckstrom vorhanden ist.

6. Stromdetektionsschaltung (20) nach Anspruch 5, bei der das Vergleichsmodul (22) des Weiteren eine erste Operationsverstärkereinheit (22b) aufweist, die zwischen der Vergleichseinheit (22a) und dem Erregungsmodul (21) angeschlossen ist;
wobei die erste Operationsverstärkereinheit (22b) so konfiguriert ist, dass sie eine Signalverstärkungsverarbeitung an dem Rückkopplungssignal (Sk) durchführt, bevor das effektive Signal und das Störsignal in dem Rückkopplungssignal (Sk) bestimmt werden.

7. Stromdetektionsschaltung (20) nach Anspruch 5, bei der das Vergleichsmodul (22) des Weiteren eine zweite Operationsverstärkereinheit (22c) aufweist, die mit der Vergleichseinheit (22a) verbunden ist;
wobei die zweite Operationsverstärkereinheit (22c) so konfiguriert ist, dass sie eine Leistungsverstärkungsverarbeitung an dem zweiten Signal (Z2) durchführt.

8. Stromdetektionsschaltung (20) nach Anspruch 1, bei der das Hilfsmodul (24) einen Stromgenerator aufweist.

9. Ladesystem mit einer Ladevorrichtung (101), einer magnetischen Induktionsspule (10), einer Steuerschaltung (103) und der Stromdetektionsschaltung (20) nach einem der Ansprüche 1 bis 8;
wobei die Stromdetektionsschaltung (20) mit der magnetischen Induktionsspule (10) bzw. der Steuerschaltung (103) verbunden ist und die Steuerschaltung (103) mit der Ladevorrichtung (101) über eine erste Leitung (104) verbunden ist, die durch die magnetische Induktionsspule (10) verläuft;
wobei die Stromdetektionsschaltung (20) so konfiguriert ist, dass sie ein Anzeigesignal ausgibt, wenn festgestellt wird, dass in der ersten Leitung (104) ein Leckstrom vorhanden ist;
wobei die Steuerschaltung (103) so konfiguriert ist, dass sie die Ladevorrichtung (101) so steuert, dass sie bei Empfang des Anzeigesignals die Zufuhr elektrischer Energie nach außen stoppt, und die Ladevorrichtung (101) so steuert, dass sie bei Nicht-Empfang des Anzeigesignals elektrische Energie nach außen zuführt.

10. Ladesystem nach Anspruch 9, bei dem die erste Leitung (104) eine neutrale Leitung und eine stromführende Leitung aufweist.

11. Leckstrom-Detektionsverfahren zum Bestimmen, ob es einen Leckstrom in einer Leitung (L0) gibt, die durch eine magnetische Induktionsspule (10) geführt wird, die eine erste Wicklung (u1) aufweist, wobei das Leckstrom-Detektionsverfahren aufweist:
Ausgeben eines Erregungssignals durch ein Erregungsmodul (21) an die erste Wicklung (u1), wobei das Erregungsmodul (21) mit der ersten Wicklung (u1) verbunden ist; und
Bestimmen, durch ein Vergleichsmodul (22), ob es einen Leckstrom in einer Leitung (L0) gibt, die durch die magnetische Induktionsspule (10) verläuft, basierend auf einem Rückkopplungssignal (Sk), das durch die erste Wicklung (u1) induziert wird, und einem voreingestellten Referenzsignal, wobei das Vergleichsmodul (22) mit dem Erregungsmodul (21) verbunden ist;
**dadurch gekennzeichnet, dass**
die magnetische Induktionsspule (10) des Weiteren eine zweite Wicklung (u2) aufweist, und das Leckstrom-Detektionsverfahren des Weiteren aufweist:
Ausgeben eines voreingestellten Stromsignals durch ein Hilfsmodul (24) an die zweite Wicklung (u2) in einer Initialisierungsphase, in der kein Strom durch die Leitung (L0) fließt, um zu bestimmen, ob das Erregungsmodul (21) und das Vergleichsmodul (22) normal arbeiten können, wobei das voreingestellte Stromsignal ein Magnetfeld ändert, das durch das Erregungssignal erzeugt wird, wenn das Erregungsmodul (21) das Erregungssignal in die erste Wicklung (u1) eingibt.

## Revendications

1. Circuit de détection de courant (20) pour déterminer si un courant de fuite est présent dans une ligne (L0) passant à travers une bobine d'induction magnétique (10) ayant un premier enroulement (u1), le circuit de détection de courant (20) comprenant un module d'excitation (21) et un module de comparaison (22), le module d'excitation (21) étant configuré pour être connecté au premier enroulement (u1), et le module de comparaison (22) étant connecté au module d'excitation (21) ;
dans lequel le module d'excitation (21) est configuré pour émettre un signal d'excitation vers le premier enroulement (u1) et pour recevoir un signal de rétroaction (Sk) induit par le premier enroulement (u1);
dans lequel le module de comparaison (22) est configuré pour déterminer si un courant de fuite est présent dans la ligne (L0) sur la base du signal de rétroaction (Sk) induit par le premier enroulement (u1) et d'un signal de référence préétabli;
**caractérisé en ce que**
la bobine d'induction magnétique (10) comprend en outre un second enroulement (u2);
le circuit de détection de courant (20) comprend en outre un module auxiliaire (24), et le module auxiliaire (24) est configuré pour être connecté au deuxième enroulement (u2);
le module auxiliaire (24) est configuré pour délivrer un signal de courant préréglé au deuxième enroulement (u2) dans une phase d'initialisation dans laquelle aucun courant ne circule dans la ligne (L0) afin de déterminer, si le module d'excitation (21) et le module de comparaison (22) sont capables de fonctionner normalement, le signal de courant préréglé modifiant un champ magnétique généré par le signal d'excitation lorsque le module d'excitation (21) applique le signal d'excitation au premier enroulement (u1).

2. Circuit de détection de courant (20) selon la revendication 1, dans lequel le module de comparaison (22) est configuré spécifiquement à cet effet:
de déterminer si une valeur absolue du signal de rétroaction (Sk) est supérieure au signal de référence;
de déterminer qu'un courant de fuite est présent dans la ligne (L0) lorsque la valeur absolue du signal de rétroaction (Sk) est supérieure au signal de référence;
de déterminer qu'il n'y a pas de courant de fuite dans la ligne (L0) lorsque la valeur absolue du signal de rétroaction (Sk) n'est pas supérieure au signal de référence.

3. Circuit de détection de courant (20) selon la revendication 1, dans lequel le module d'excitation (21) comprend un générateur de signal (21a) configuré pour générer le signal d'excitation.

4. Circuit de détection de courant (20) selon la revendication 3, dans lequel le module d'excitation (21) comprend en outre une unité de division de tension (21b) connectée entre le générateur de signal (21a) et le premier enroulement (u1);
l'unité de division de tension (21b) est configurée pour effectuer un traitement de division de tension sur le signal d'excitation avant que le signal d'excitation ne soit délivré au premier enroulement (u1).

5. Circuit de détection de courant (20) selon la revendication 1, dans lequel le module de comparaison (22) comprend une unité de comparaison (22a);
l'unité de comparaison (22a) est configurée pour:
déterminer un signal effectif et un signal parasite dans le signal de rétroaction (Sk) et on amplifie le signal effectif pour obtenir un premier signal (Z1);
déterminer si un courant de fuite est présent dans la ligne (L0), sur la base du premier signal (Z1) et du signal de référence; et
délivrer un deuxième signal (22) lorsqu'il est déterminé qu'un courant de fuite est présent dans la ligne (L0).

6. Circuit de détection de courant (20) selon la revendication 5, dans lequel le module de comparaison (22) comprend en outre une première unité d'amplification opérationnelle (22b) connectée entre l'unité de comparaison (22a) et le module d'excitation (21);
dans lequel la première unité d'amplification opérationnelle (22b) est configurée pour effectuer un traitement d'amplification de signal sur le signal de rétroaction (Sk) avant de déterminer le signal effectif et le signal parasite dans le signal de rétroaction (Sk).

7. Circuit de détection de courant (20) selon la revendication 5, dans lequel le module de comparaison (22) comprend en outre une deuxième unité d'amplification opérationnelle (22c) connectée à l'unité de comparaison (22a);
dans lequel la seconde unité d'amplification opérationnelle (22c) est configurée pour effectuer un traitement d'amplification de puissance sur le second signal (Z2) .

8. Circuit de détection de courant (20) selon la revendication 1, dans lequel le module auxiliaire (24) comprend un générateur de courant.

9. Système de charge comprenant un dispositif de charge (101), une bobine d'induction magnétique (10), un circuit de commande (103) et le circuit de détection de courant (20) selon l'une quelconque des revendications 1 à 8;
dans lequel le circuit de détection de courant (20) est connecté à la bobine d'induction magnétique (10) et au circuit de commande (103), respectivement, et le circuit de commande (103) est connecté au dispositif de charge (101) par l'intermédiaire d'une première ligne (104) qui passe par la bobine d'induction magnétique (10);
dans lequel le circuit de détection de courant (20) est configuré pour émettre un signal d'indication lorsqu'il est déterminé qu'un courant de fuite est présent dans la première ligne (104);
dans lequel le circuit de commande (103) est configuré pour commander le dispositif de charge (101) de manière à arrêter l'alimentation en énergie électrique vers l'extérieur lors de la réception du signal d'indication, et pour commander le dispositif de charge (101) de manière à alimenter en énergie électrique vers l'extérieur lors de la non-réception du signal d'indication.

10. Système de charge selon la revendication 9, dans lequel la première ligne (104) comprend une ligne neutre et une ligne conductrice de courant.

11. Procédé de détection de courant de fuite pour déterminer s'il y a un courant de fuite dans une ligne (L0) passant à travers une bobine d'induction magnétique (10) ayant un premier enroulement (u1), le procédé de détection de courant de fuite comprenant:
sortir d'un signal d'excitation par un module d'excitation (21) vers le premier enroulement (u1), le module d'excitation (21) étant connecté au premier enroulement (u1); et
déterminer, par un module de comparaison (22), s'il y a un courant de fuite dans une ligne (L0) passant par la bobine d'induction magnétique (10), sur la base d'un signal de rétroaction (Sk) induit par le premier enroulement (u1) et d'un signal de référence préétabli, le module de comparaison (22) étant connecté au module d'excitation (21);
**caractérisé en ce que**
la bobine d'induction magnétique (10) comprend en outre un second enroulement (u2), et le procédé de détection de courant de fuite comprend en outre:
sortir d'un signal de courant préréglé par un module auxiliaire (24) vers le second enroulement (u2) dans une phase d'initialisation dans laquelle aucun courant ne circule dans la ligne (L0) pour déterminer si le module d'excitation (21) et le module de comparaison (22) peuvent fonctionner normalement, le signal de courant préréglé modifiant un champ magnétique généré par le signal d'excitation lorsque le module d'excitation (21) entre le signal d'excitation dans le premier enroulement (u1).
